# EUROPÄISCHE PATENTANMELDUNG

(11) **EP 0 806 890 A2**
(43) Veröffentlichungstag der Anmeldung: **12.11.1997**
(21) Anmeldenummer: 97104668.5
(22) Anmeldetag: 19.03.1997
(51) Int. Cl.: H05K 9/00

(54) **Anordnung zur Abschirmung von hochfrequenter elektromagnetischer Strahlung**

(30) Priorität: 10.05.1996 DE 19618766
(71) Anmelder: Leybold Systems GmbH, D-63450 Hanau am Main (DE)
(72) Erfinder: Schuhmacher, Manfred, 63755 Alzenau (DE); Teschner, Götz, 63450 Hanau (DE); Kunz, Johannes, 63594 Hasselroth (DE); Medek, Oldrich, 63477 Maintal (DE)

(57) **Zusammenfassung**

Die Erfindung betrifft eine Anordnung zum Einschluß von in Hohlräumen erzeugten elektromagnetischen, vorzugsweise hochfrequenten Wechselfeldern, deren Entweichen aus für elektromagnetische Strahlung durchlässigen und mit Deckein verschließbaren Öffnungen zu vermeiden ist. Hierzu sind zwischen den die Öffnungen verschließenden Deckeln und dem Auflagebereich der Kammerwand HF-Dichtelemente angeordnet. Die HF-Dichtelemente bestehen aus elastisch verformbaren und elektrische Leiterelemente aufweisenden HF-Dichtungen, mittels welcher der Kammerdeckel auf der Kammerwand und mit dieser durch die HF-Dichtungselemente elektrisch leitend verbunden aufliegt. Der räumliche Abstand zweier benachbarter Dichtelemente ist kleiner als λ/4 der minimal abzuschirmenden Strahlungswelle λ.

## Beschreibung

Die Erfindung betrifft eine Anordnung zur Abschirmung hochfrequenter elektromagnetischer Wechselfeldstrahlung, mittels welcher der Austritt von vorzugsweise in Hohlräumen vorhandener HF-Strahlung aus deren abdeckbaren Öffnungen unterbindbar ist.

Maßnahmen und Vorrichtungen zur gezielten Abschirmung und Unterdrückung des Austritts von elektromagnetischen, hochfrequenten Wechselfeldern aus diese umgebende Hohlkörper sind bekannt. So ist insbesondere bei der konstruktiven Auslegung von regelmäßig zu öffnenden und zu verschließenden Durchtrittsöffnungen der Hohlkörper, z.B. Türöffnungen, darauf zu achten, daß die die Öffnungen abdeckenden Abschirmelemente in gutem elektrischen Kontakt zu den den Hohlkörper begrenzenden Kammerwänden stehen, und daß zwischen den Kammerwänden und den die Öffnungen verschließenden Abschirmvorrichtungen keine HF-Lecks, z.B. durch verbleibende Spaltöffnungen, entstehen. Derartige Spaltöffnungen wirken insbesondere bei Spaltgrößen von λ/4 der Wellenlänge λ der vorhandenen elektromagnetischen Strahlung als Spaltantenne, durch welche die abzuschirmende elektromagnetische Strahlung sehr effektiv entweichen kann.

Abzuschirmende, hochfrequente elektrische und/oder magnetische Wechselfelder entstehen z.B. beim Betrieb von zur Kathodenzerstäubung und -beschichtung von Oberflächen verwendeten Magnetrons. Bei derartigen Magnetrons wird mittels eines hochfrequenten elektrischen Wechselfeldes eine elektrische Entladung zwischen einer zu zerstäubenden Kathode und einer dieser zugeordneten Anode aufrecht erhalten. Die typischen Betriebsfrequenzen derartiger Kathodenzerstäubungsvorrichtungen betragen bis zu ca. 40 MHz. Da die Kathodenzerstäubungsverfahren unter Vakuumbedingungen stattfinden, sind die hierfür vorgesehenen Prozeßkammern häufig mittels Gummidichtungen zwar vakuumdicht, jedoch nicht ohne weiteres auch HF-dicht beschaffen.

Insbesondere die zur Pflege und Wartung, z.B. zum Auswechseln der Sputterkathoden notwendigen, in den Prozeßkammern vorgesehenen, verschließbaren Öffnungen erweisen sich nach mehrmaligem Öffnen und Schließen als nicht konstant HF-dicht mit der Folge, daß die aus derartigen Prozeßkammern austretende elektromagnetische Strahlung als Störsignal wirkt und wegen der zur Sputterzerstäubung notwendigen hohen Strahlungsleistungen z.B. den Radioempfang empfindlich stören kann.

Aufgabe der vorliegenden Erfindung ist es, eine Anordnung zur Abschirmung elektromagnetischer Strahlung zu schaffen, mittels welcher insbesondere der Austritt von in einem Hohlraum vorhandenen elektrischen und/oder magnetischen Feldern, insbesondere auf Grund von Strahlungslecks bei verschließbaren Hohlraumöffnungen, vermieden wird.

Die Lösung der gestellten Aufgabe erfolgt erfindungsgemäß dadurch, daß die gegen den Austritt von elektromagnetischen Wechselfeldern zu verschließenden Hohlkörperöffnungen mit einem für elektromagnetische Strahlung undurchlässigen, abschirmenden Plattenkörper abgedeckt werden, und wobei zwischen dem Plattenkörper und der äußeren Kammerwand des Hohlkörperraumes Hochfrequenz(HF)-Dichtungen vorgesehen sind, welche im wesentlichen aus elektrisch leitendem und elastisch verformbarem Material bestehen, mit welchem der Plattenkörper und die Kammerwand elektrisch leitend miteinander in Kontakt gebracht sind. Die HF-Dichtungsanordnung besteht aus einzelnen HF-Dichtelementen, die auf dem Umfangsbereich der gegen HF-Strahlung abzudichtenden, verschließbaren Kammeröffnung des Plattenkörpers angeordnet sind, wobei der maximale Abstand zweier benachbarter HF-Dichtungselemente kleiner ist als λ/4, vorzugsweise kleiner als λ/40 der abzuschirmenden elektromagnetischen Strahlungswellenlänge. Eine vorteilhaft dichte HF-Dichtungsanordnung wird dadurch bewirkt, daß die HF-Dichtungselemente vorzugsweise in einer in dem Plattenkörper vorgesehenen Nute angeordnet sind, wobei vorgesehen ist, daß die HF-Dichtungselemente in Führungen gelagert sind, wobei die HF-Dichtungselemente innerhalb der zwischen dem dichtenden Deckel und dem abzudichtenden Gehäuse ausgebildeten geometrischen Fertigungstoleranzen in ihrer HF-dichtenden Position einstellbar sind. Die aus den HF-Dichtungselementen jeweils endseitig herausragenden Leiterstränge liegen an den Kontaktierungsflächen des Kammerdeckels und der Kammerwand an. Auf Grund der Elastizität der HF-Dichtelemente und ihrer begrenzten Verschiebbarkeit ist vorteilhaft gewährleistet, daß die Gehäusewandung und der Deckel über die HF-Dichtungselemente auch nach mehrmaligem Öffnen und Schließen elektrisch in Kontakt stehen. Alternativ ist vorgesehen, daß die HF-Dichtungselemente auch unmittelbar auf dem keine Nute aufweisenden Plattenkörper angeordnet sind.

Ein weiterer Vorteil ergibt sich insbesondere bei der Abdichtung von Prozeßkammern, in welchen Puls-Plasmen betrieben werden, welche z.B. bei der PVD-Technik zur Plasmabeschichtung, Plasmaätzung und dem Puls-Sputtern zum plasmaaktivierten Bedampfen von Schichten oder Werkstücken unter Vakuumbedingungen zum Einsatz kommen. Zur Erzeugung und Aufrechterhaltung der während des Plasmaprozesses notwendigen Vakuumdrücke sind die Zugangsöffnungen der Prozeßkammer mittels herkömmlicher Vakuumdichtelemente, die z.B. aus elastisch verformbaren Material (O-Ringe) bestehen, abgedichtet.

Die Vakuumdichtelemente liegen dabei in einer z.B. in dem Deckel ausgebildeten Nute. Erfindungsgemäß ist mit besonderem Vorteil möglich, sowohl die Vakuumdichtelemente als auch die HF-Dichtungselemente gemeinsam in einer entweder in dem zur Abdeckung der Öffnungen vorgesehenen Plattenkörper oder der Gehäusekammerwand ausgebildeten gemeinsam genutzten Nute anzuordnen. Hierzu ist erfindungsgemäß vorgesehen, die Vakuumdichtungen mittels einer in der Nute eingesetzten Leiste lösbar zu fixieren, wobei in der Leiste auch Führungen zur Aufnahme der HF-Dichtungselemente vorgesehen sind. Die Integration sowohl der Vakuumdichtelemente als auch der HF-Dichtungen vorzugsweise in einer einzigen Nute vereinfacht vorteilhaft den konstruktiven Aufwand und erlaubt eine kostengünstige Herstellung einer vakuum- und hochfrequenzdichten Prozeßkammer.

Die Vakuumdichtung kann auch aus zwei zueinander parallel verlaufenden, umlaufenden Dichtelementen bestehen, wobei die HF-Dichtelemente zwischen den Vakuumdichtelementen angeordnet sind. Die HF-Dichtelemente sind dadurch vorteilhaft gegen mechanische und korrosionsbedingte Beschädigungen geschützt.

Die HF-Dichtelemente und/oder die Vakuumelemente werden mittels einer austauschbaren Dichtungsleiste in der Nute befestigt. Dieses ermöglicht, vorhandene HF-Kammern und auch solche, die zudem auch noch evakuierbar sind, mit der erfindungsgemäßen HF-Dichtung und gegebenenfalls in Kombination mit Vakuumdichtelementen nachzurüsten.

Die einzelnen HF-Dichtelemente bestehen aus in elastisch verformbares Material eingebetteten, dünnen, flexiblen Einzelleitern. Diese Einzelleiter ragen jeweils mit ihren beiden Enden aus dem elastischen Grundkörper heraus und liegen jeweils an der Kammerwand und dem Kammerdeckel an, wobei eventuell auf der Kammerwand und/oder dem Kammerdeckel ausgebildete, elektrisch isolierende Oxydschichten durch die Leiterenden durchbrochen werden und einen elektrisch leitenden Kontakt zwischen Kammerwand und Kammerdeckel herstellen. Dies ermöglicht, die erfindungsgemäße HF-Dichtung auch bei von einer dünnen Oxydschicht bedeckten Kammerwänden bzw. Plattenkörpern wirksam einzusetzen.

Weitere vorteilhafte Ausgestaltungen des Erfindungsgegenstandes ergeben sich aus den übrigen Unteransprüchen.

Der Erfindungsgegenstand wird anhand mehrerer, in den Figuren 1 bis 11 dargestellter, besonders vorteilhafter Ausführungsbeispiele näher erläutert.

Es zeigen:
- Fig. 1: eine Aufsicht auf die Dichtungsseite eines eine Vakuumdichtung und eine HF-Dichtung aufweisenden rechteckigen Prozeßkammerdeckel,
- Fig. 2: einen vergrößerten, gebrochenen Ausschnitt der in Fig. 1 dargestellten Dichtungsleiste,
- Fig. 3a: eine Schnittansicht entlang der in Fig. 2 dargestellten Schnittlinie A-A',
- Fig. 3b: eine Schnittansicht entlang der in Fig. 2 eingezeichneten Schnittlinie B-B',
- Fig. 4a: eine vergrößerte Darstellung der in Fig. 3b dargestellten Schnittansicht einer Dichtungsleiste mit zugeordneten Vakuumdichtelementen und HF-Dichtelementen,
- Fig. 4b: eine vergrößerte Darstellung der in Fig. 3a dargestellten Dichtungsleiste mit zugeordneten Vakuumdichtelementen und Befestigungsschraube,
- Fig. 5: eine Schnittansicht durch eine in einer Nute angeordneten Vakuum- und HF-Dichtungsvorrichtung nach einem zweiten Ausführungsbeispiel,
- Fig. 6: eine in einer Nute angeordnete Vakuum- und HF-Dichtungsvorrichtung nach einem dritten Ausführungsbeispiel,
- Fig. 7: eine in einer Nute angeordnete Vakuum- und HF-Dichtungsvorrichtung nach einem vierten Ausführungsbeispiel,
- Fig. 8: eine in einer Nute angeordnete Vakuum- und HF-Dichtungsvorrichtung nach einem fünften Ausführungsbeispiel,
- Fig. 9: eine Rückansicht einer Dichtungsleiste mit zwei der in Fig. 8 dargestellten HF-Dichtungselemente,
- Fig. 10: eine Rückansicht einer Dichtungsleiste mit in dieser eingesetztem HF-Dichtungselement nach einem weiteren Ausführungsbeispiel und
- Fig. 11: eine Rückansicht einer Dichtungsleiste nach einem weiteren Ausführungsbeipiel mit in dieser eingesetztem HF-Dichtungselement.

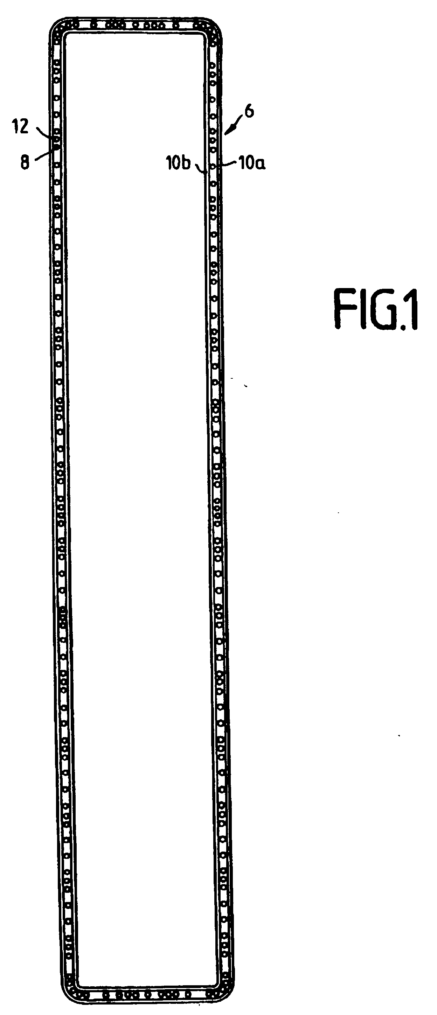

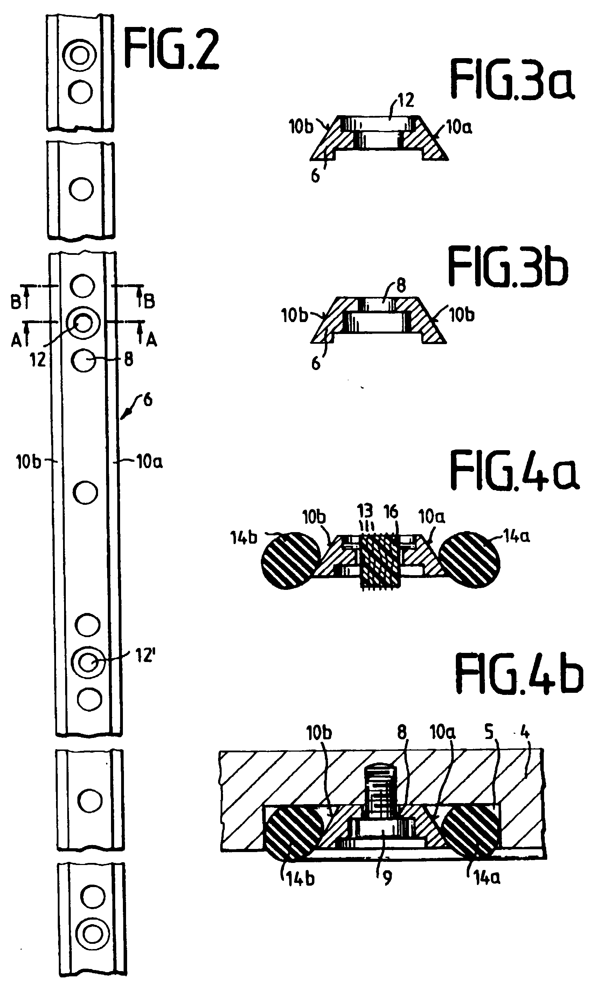

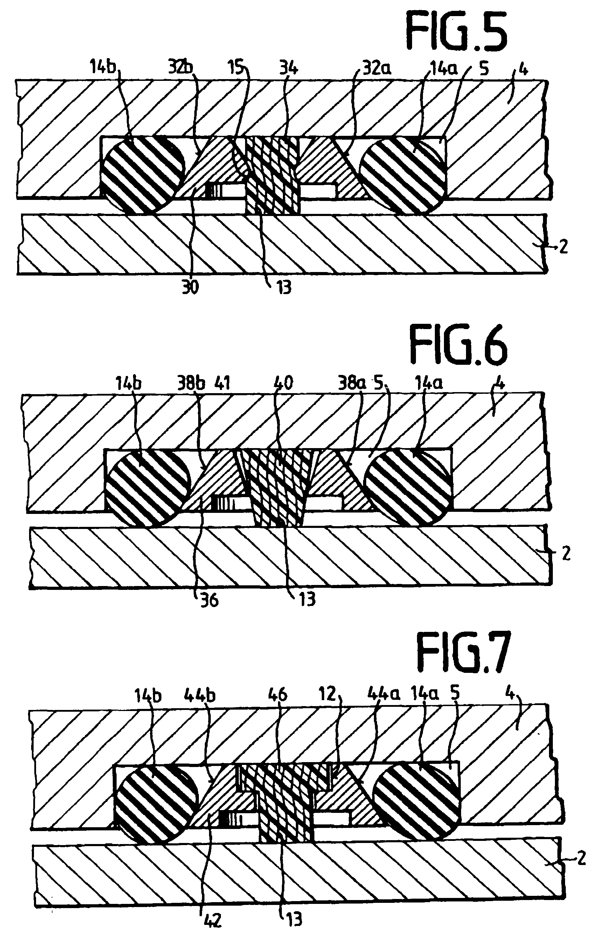

Der in Fig. 1 dargestellte, im wesentlichen rechteckige Gehäusedeckel 4 weist in seinem Außenrandbereich eine umlaufende Nute 5 zur Aufnahme einer Dichtungsleiste 6, Vakuumdichtelemente 14a,14b und HF-Dichtungselemente 16,16',16'',... (siehe Fig. 4a,4b) auf. Die Vakuumdichtelemente 14a,14b bestehen aus in ihrem vorzugsweise kreisförmigen Querschnitt elastisch verformbaren Gummiringen, welche mit ihrer Umfangsfläche einerseits an der Kammerwand 2 und andererseits an dem Gehäusedeckel 4 vakuumdicht anliegen (siehe Fig. 5 - Fig. 8). Die Vakuumdichtungen 14a,14b werden in der Nute 5 mittels der in dieser lösbar zu befestigenden Dichtungsleiste 6,22,30,36,42 gehalten. Die Dichtungsleisten 6, 22, 30, 36, 42 sind jeweils einstückig entlang einer Öffnungsseite ausgebildet und weisen jeweils parallel zueinander und parallel zur Nute 5 verlaufende Rampen 32a,32b; 38a,38b; 44a,44b; 50a,50b (siehe Fig. 5 - Fig. 8) auf, an welche die Vakuumdichtungen 14a,14b unter leichtem Druck anliegen, wodurch diese in der Nute 5 gegen seitliches Verrutschen und Herausfallen in einer zum Kammerdeckel 4 und der Kammerwand 2 raumfesten Position gesichert sind.

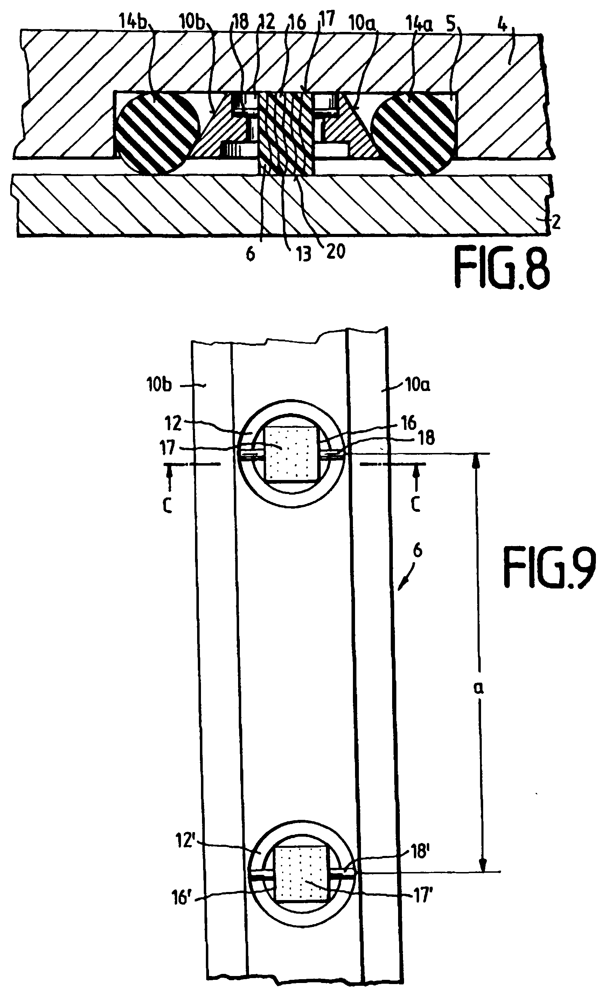

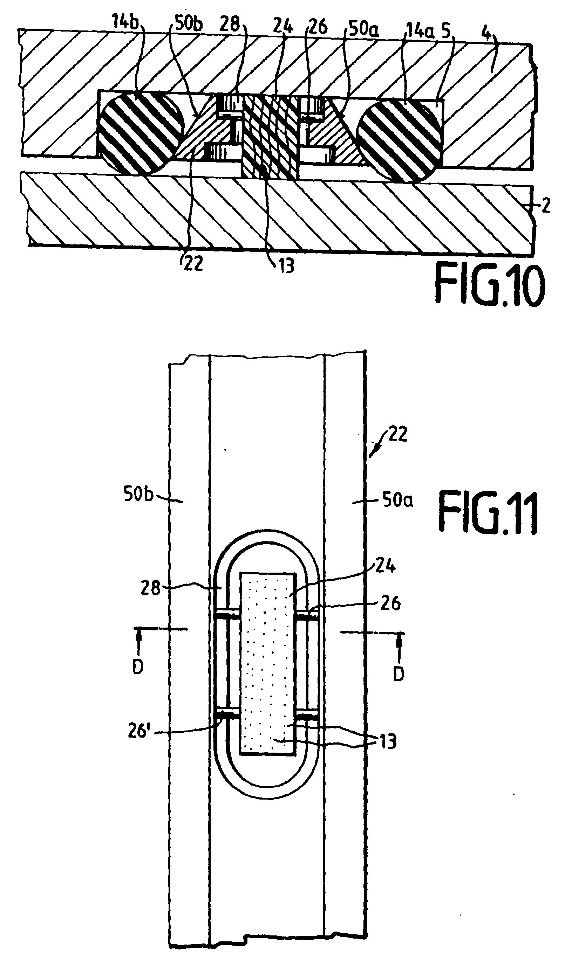

Die HF-Dichtungselemente 16,16',16'',...; 24,24',...;34,34',...;40,40',...;46,46',46'',... sind in in der Dichtungsleiste 6,22,30,36,42 vorgesehenen Führungen 12,12' (siehe Fig. 3b) eingesetzt und in diesen reibschlüssig in eine Verschieberichtung zur Gehäusewand 2 gelagert. Mittels Arretierstiften 18,18' (siehe Fig. 8 - Fig. 11) sind die Dichtungselemente 16,16' gegen ein unbeabsichtigtes Herausfallen gesichert. Die HF-Dichtungs-elemente 16,16'; 24,24',...; 34,34',...;40,40',...;46,46',... bestehen aus üblichen HF-Dichtungen, welche aus einem Elastomer mit in diesem eingegossenen, leitfähigen Metallfäden hergestellt ist. Die Metallfäden ragen an den auf der Gehäusewand 2 und der dem Gehäusedeckel 4 gegenüberliegenden Kantenflächen aus dem Elastomermaterial, z.B. Silikon, frei heraus und werden beim Verschließen der Gehäusewand 2 mit dem Gehäusedeckel 4 einerseits auf dem letzteren und der Gehäusewand 2 andererseits auf Kontaktierungsflächen 17,17' bzw. 20,20' anliegend gedrückt. Isolierende, auf den Kontaktflächen sich ausbildende Oxydschichten werden durch die Metallflächen lokal aufgebrochen und durchstoßen und die elektrisch leitende Verbindung zwischen Gehäusewand 2 und dem Gehäusedeckel 4 hergestellt.

Gemäß dem in Fig. 9 dargestellten Ausführungsbeispiel sind im wesentlichen HF-Dichtungselemente 16,16' mit quadratischen Kontaktierungsflächen 17,17' vorgesehen und in einem Abstand **a** fortlaufend in der Dichtungsleiste 6 (siehe Fig. 8, Fig. 9) angeordnet. Der zwischen benachbarten HF-Dichtungselementen 16,16' zu wählende Abstand **a** bestimmt sich nach der minimalen Wellenlänge λ der vorhandenen abzuschirmenden elektromagnetischen Strahlung. Gute Abschirmeigenschaften mit hoher Dämpfung ergeben sich, wenn der Abstand **a** < λ/4 der abzuschirmenden Strahlungswellenlänge λ ist. In Versuchsreihen hat sich herausgestellt, daß für Werte von a < λ/40 eine sehr effektive und nahezu keine elektromagnetische Strahlung durchlässige HF-Dich-tungsanordnung herstellbar ist.

Bei der in Fig. 11 dargestellten HF-Dichtungsanordnung besitzt das HF-Dichtungselement 24,24' eine sich entlang der Nute 5 erstreckende Quaderform, welche jeweils mittels zweier Arretierstifte 26,26' in der Führung 28 gehaltert wird.

Anstatt durch die Arretierstifte 18,18' (siehe Fig. 9) bzw. 26,26' (siehe Fig. 11) wird das HF-Dichtungselement 34 (siehe Fig. 5) reibschlüssig in der Dichtungsleiste 30 gehaltert, wobei in dieser ein Profil 15 ausgebildt ist, welches in ein auf dem Außenumfang des HF-Dich-tungselementes 34 ausgebildetes Konterprofil eingreift.

Alternativ zu der in der Fig. 5 dargestellten Ausformung des in der Dichtungsleiste 32a,32b ausgebildeten Profils 15 ist ein in Fig. 6 in den Leistensträngen 38a,38b ausgebildetes konisches Profil 41 vorgesehen, in welches das HF-Dichtungselement 40 trichterförmig hineinragt und gegen ein Herausfallen aus der Dichtungsleiste 36 gesichert ist.

Alternativ zur reibschlüssigen Arretierung wie bei den HF-Dichtungselementen 34,40 ist, wie in Fig. 7 dargestellt, das HF-Dichtungselement 46 formschlüssig in entsprechend ausgeformte profilierte Aufnahmen der Dichtungsleiste 42 eingesetzt. Hierdurch wird ein Herausfallen des HF-Dichtungselementes 46 aus der Dichtleiste 42 wirksam verhindert, wobei auf zusätzliche Arretierstifte vollständig verzichtet werden kann.

Die Dichtungsleiste 6 kann mittels mehrerer, in dieser abständig zueinander angeordneten Durchgangslöchern 8 (siehe Fig. 3a) mittels Schrauben 9 (siehe Fig. 4b) in der Nute 5 (siehe Fig. 4b, Fig. 8) befestigt werden. Hierdurch ist ein schnelles Auswechseln bzw. Erneuern einer Vakuumdichtung mit integrierter HF-Dichtanordnung auch bei schon bestehendem und z.B. eine Nute aufweisendem Gehäusedeckel bzw. Kammerwand möglich.

### Bezugszeichenliste

- 2: Kammerwand, Gehäusewand
- 4: Gehäusedeckel, Kammerdeckel
- 5: Nute
- 6: Dichtungsleiste
- 8: Durchgang
- 9: Schraube
- 10a,10b: Seitenfläche
- 12: HF-Dichtungsaufnahme, HF-Dichtungsführung
- 13: Metallfäden
- 14a,14b: Vakuumdichtelement, Vakuumdichtung
- 15: Profil
- 16,16': HF-Dichtungselement
- 17,17': Kontaktierungsfläche an 4
- 18,18': Arretierstift
- 20,20': Kontaktierungsfläche an 2
- 22: Dichtungsleiste
- 24,24',24'',...: HF-Dichtungselement
- 26,26': Arretierstift
- 28: Durchgangslangloch
- 30: Dichtungsleiste
- 32a,32b: Rampe
- 34,34',34'',...: HF-Dichtung, HF-Dichtungselement
- 36: Dichtungsleiste
- 38a,38b: Rampe
- 40,40',40'',...: HF-Dichtung, HF-Dichtungselement
- 41: Profil
- 42: Dichtungsleiste
- 44a,44b: Rampe
- 46,46',46'',...: HF-Dichtungselement
- 50a,50b: Rampe
- **a**: HF-Dichtungselementabstand

## Patentansprüche

1. Anordnung zur Abschirmung von in Hohlräumen vorhandenen elektromagnetischen Feldern, insbesondere zur Abschirmung von elektrischen und/oder magnetischen, hochfrequenten Wechselfeldern gegen den Austritt aus für elektromagnetische Strahlung durchlässige Öffnungen, welche vorzugsweise mittels lösbarer, für elektromagnetische Strahlung undurchlässige Plattenkörper (4) verschließbar sind, wobei auf die Plattenkörper (4) vorzugsweise im Bereich ihres Außenumfangs und/oder auf die zu verschließende Kammerwandöffnung im Bereich des Öffnungsrandes HF-Dichtelemente (16,16',...;24,24',...;34,34',...;40,40',...; 46,46',...), vorzugsweise bestehend aus elastisch verformbaren, elektrischen Leitern, aufweisende HF-Dichtung angeordnet sind, mittels welcher der Plattenkörper (4) auf der Kammerwand (2) und mit dieser durch die HF-Dichtungselemente (16,16',...;24,24',...; 34,34',...;40,40',...;46,46',...) elektrisch leitend verbunden aufliegt, und wobei der Abstand **a** zweier benachbarter Dichtelemente (16,16') kleiner ist als λ/4 der minimal abzuschirmenden Strahlungswellenlänge λ.

2. Anordnung nach Anspruch 1, wobei die Plattenkörper (4) vorzugsweise im Bereich ihres Außenumfanges und/oder die zu verschließende Kammerwandöffnung im Bereich des Öffnungsrandes eine in sich geschlossene und umlaufende Nute (5) aufweisen, und daß in der Nute (5) mindestens ein Vakuumdichtelement (16,16',...;24,24',...;34,34',...;40,40',...; 46,46',...) angeordnet ist, mittels welchem die Kammeröffnung vakuumdicht verschließbar ist.

3. Anordnung nach Anspruch 1 und/oder 2, wobei die HF-Dichtung (16,16',...;24,24',...; 34,34',...;40,40',...;46,46',...) einerseits und die Vakuumdichtung (14a,14b) andererseits gemeinsam mittels einer vorzugsweise in der Nute (5) angeordneten und mit dem Kammerdeckel (4) vorzugsweise lösbar verbundenen Profildichtungsleiste (6,22,30,36,42) fixierbar ist.

4. Anordnung nach mindestens einem der Ansprüche 1 bis 3, wobei die HF-Dichtelemente (16,16',...;24,24',...;34,34',...;40,40',...; 46,46',...), mittels Reibschluß (34,40) oder mittels Formenschluß (46) in der Dichtungsleiste (30;36,42) geführt sind.
